# EUROPÄISCHE PATENTSCHRIFT

(11) **EP 1 730 759 B1**
(45) Veröffentlichungstag und Bekanntmachung des Hinweises auf die Patenterteilung: **23.12.2009**
(21) Anmeldenummer: 05715647.3
(22) Anmeldetag: 02.03.2005
(51) Int. Cl.: H01H 27/00

(54) **SICHERHEITSSCHALTER ZUM ÜBERWACHEN EINER SCHLIESSPOSITION ZWEIER RELATIV ZUEINANDER BEWEGLICHER TEILE**
SAFETY SWITCH FOR MONITORING A CLOSED POSITION OF TWO PARTS THAT ARE MOVABLE RELATIVE TO ONE ANOTHER
INTERRUPTEUR DE SECURITE POUR SURVEILLER LA POSITION FERMEE DE DEUX PARTIES SE DEPLACANT L'UNE PAR RAPPORT A L'AUTRE

(30) Priorität: 29.03.2004 DE 102004016632; 12.08.2004 DE 102004039974
(43) Veröffentlichungstag der Anmeldung: 13.12.2006
(73) Patentinhaber: Pilz GmbH & Co. KG, 73760 Ostfildern (DE)
(72) Erfinder: PULLMANN, Jürgen, 73061 Ebersbach (DE); ZINSER, Christoph, 72649 Wolfschlugen (DE)
(74) Vertreter: Duhme, Torsten
(86) Internationale Anmeldenummer: PCT/EP2005/002169
(87) Internationale Veröffentlichungsnummer: WO 2005/106909

(56) Entgegenhaltungen:
- EP-A- 0 665 405
- DE-A1- 10 216 225
- DE-A1- 19 711 588
- DE-C1- 10 222 186
- DE-C1- 19 602 690

## Beschreibung

Die vorliegende Erfindung betrifft einen Sicherheitsschalter zum Überwachen einer Schließposition zweier relativ zueinander beweglicher Teile, insbesondere zum Überwachen einer Schutztür an einer automatisierten Anlage, mit einem Betätiger und mit einem Sensor, die an jeweils einem der Teile fixierbar sind, wobei der Betätiger zumindest ein Bauelement aufweist, das dazu ausgebildet ist, ein von der Schließposition der Teile abhängiges Sendesignal zu erzeugen, und wobei der Sensor dazu ausgebildet ist, das Sendesignal auszuwerten, um die Schließposition zu detektieren.

Ein solcher Sicherheitsschalter ist aus DE 197 11 588 A1 oder DE 196 24 172 bekannt.

Gattungsgemäße Sicherheitsschalter werden vor allem im Bereich der Maschinen- und Anlagensicherheit eingesetzt, um Personen vor Gefahren, die von einer automatisiert arbeitenden Anlage ausgehen, zu schützen. Neben anderen Schutzmaßnahmen, wie beispielsweise Lichtschranken, Trittmatten, Zwei-Hand-Schaltern etc. werden in solchen Anlagen häufig auch Schutztüren, Schutzklappen und ähnliches zur Absicherung eingesetzt. Die Schutztüren sind mit einer Betätiger-Sensor-Kombination versehen, die ein Öffnen der Schutztür zuverlässig, insbesondere (ein-) fehlersicher, erkennen müssen, so dass die Maschine oder Anlage gegebenenfalls in einen gefahrlosen Zustand versetzt werden kann. Geeignete Betätiger-Sensor-Kombinationen fallen damit in den Bereich derjenigen Bauteile, die für ihre Verwendung eine entsprechende Zertifizierung von Seiten zuständiger Aufsichtsbehörden benötigen. Die vorliegende Erfindung bezieht sich daher insbesondere auf Sicherheitsschalter der eingangs genannten Art, die zumindest die Kategorie 3, bevorzugt sogar die höchste Kategorie 4, der einschlägigen europäischen Norm EN 954-1 oder vergleichbare Sicherheitsanforderungen für eine Verwendung zur Absicherung von technischen Anlagen erfüllen.

Unter den gattungsgemäßen Sicherheitsschaltern haben berührungslose Betätiger-Sensor-Kombinationen eine zunehmende Aufmerksamkeit gewonnen. Derartige Sicherheitsschalter basieren in aller Regel auf magnetischen und/oder elektromagnetischen Kopplungen zwischen Betätiger und Sensor, die beim Öffnen der Schutztür unterbrochen oder gestört werden. Sicherheitsschalter, die auf einer magnetischen Kopplung basieren, eignen sich für Anwendungen im Bereich der spanabhebenden Bearbeitung von metallischen Werktücken nur bedingt, da in diesen Fällen die Gefahr besteht, dass Metallspäne am Betätiger und/oder am Sensor hängen bleiben, was dessen Funktion beeinträchtigen kann. Sicherheitsschalter, die auf der Verwendung eines Transponders beruhen, besitzen diesen Nachteil nicht und sind daher auch im Rahmen der vorliegenden Erfindung bevorzugt. Die Erfindung ist jedoch von der verwendeten Technologie grundsätzlich unabhängig und kann gleichermaßen auch bei anderen einschlägigen Sicherheitsschaltern angewendet werden.

Die Absicherung der Gefahrstellen durch Schutztüren mit entsprechenden Sicherheitsschaltern erschwert natürlich einen bewussten Zugang in den Gefahrenbereich der automatisierten Anlage. Daher kommt es in der Praxis vor, dass die Sicherheitsschalter von den Bedienpersonen der Anlage manipuliert oder gänzlich entfernt werden, beispielsweise um eine Beladung der automatisierten Anlage mit Werkstücken zu erleichtern. Damit derartige Manipulationen nicht ohne Weiteres möglich sind, werden bei gattungsgemäßen Anlagen häufig zwei redundante Sicherheitsschalter verwendet, wobei einer manchmal noch durch eine verdeckte Montage gesichert ist.

Der auf diese Weise realisierte Manipulationsschutz ist jedoch relativ teuer, da für die Absicherung einer Schutztür hiernach stets doppelte Material- und Montagekosten anfallen.

Aus DE 102 16 225 A1 ist ein gattungsgemäßer Sicherheitsschalter bekannt, der über ein elektromagnetisches Zuhaltesystem verfügt. Letzteres beinhaltet einen Elektromagneten, der dazu dient, ein Öffnen der Schutztür beispielsweise erst dann zu ermöglichen, wenn die abgesicherte Anlage in einen gefahrlosen Ruhezustand gelangt ist, wenn also beispielsweise ein bewegter Antrieb vollständig ausgelaufen ist. Um die Zuhaltung durch die elektromagnetischen Kräfte zuverlässig zu kontrollieren, wird vorgeschlagen, dass am Betätiger ein oder mehrere zusätzliche Sensorelemente angeordnet sind, mit denen das vom Elektromagneten generierte Magnetfeld und damit die Zuhaltung kontrollierbar ist. In einem konkreten Ausführungsbeispiel ist vorgeschlagen, als Sensorelement einen Reed-Kontakt zu verwenden, der die Aktivierung eines im Betätiger angeordneten Transponders freigibt oder verhindert. Ein echter Manipulationsschutz ist damit jedoch nicht verbunden, da der beschriebene Sicherheitsschalter einfach umgangen werden kann, indem man den Betätiger von dem beweglichen Teil der Schutztür demontiert und am feststehenden Teil der Schutztür im Bereich des Sensors befestigt, beispielsweise mit einem Klebestreifen auf dem Sensor festklebt. Um eine solche Manipulation zumindest zu erschweren, muss dieser bekannte Sicherheitsschalter daher auch durch einen zweiten, vorzugsweise versteckt angeordneten Sicherheitsschalter ergänzt werden.

Aus DE 102 22 186 C1 ist ein Sicherheitsschalter bekannt, der mit einem einfach aufgebauten Betätiger manipulationssicher betätigbar sein soll, wobei insbesondere der Schaltabstand einfach und manipulationssicher einstellbar sein soll. Vorgeschlagen wird hierzu ein Betätiger, der anstelle eines Transponders lediglich einen LC-Schwingkreis besitzt. Im Sensor ist eine Auswerteschaltung vorgesehen, die eine vom LC-Schwingkreis nach dessen Anregung emittierte Energiemenge bestimmt und mit einem voreingestellten Schwellenwert vergleicht. Auch dieser bekannte Sicherheitsschalter ist jedoch nicht davor geschützt, dass der Betätiger mit dem LC-Schwingkreis vom beweglichen Teil der Schutztür demontiert und im Bereich des Sensors angeordnet wird.

Vor diesem Hintergrund ist es eine Aufgabe der vorliegenden Erfindung, einen Sicherheitsschalter der eingangs genannten Art anzugeben, der auf kostengünstige Weise einen verbesserten Manipulationsschutz bietet.

Diese Aufgabe wird gemäß einem Aspekt der vorliegenden Erfindung durch einen Sicherheitsschalter der eingangs genannten Art gelöst, bei dem der Betätiger ein Befestigungsmittel zum Befestigen an dem einen der Teile aufweist, wobei das Befestigungsmittel mit dem Bauelement so verbunden ist, dass das Bauelement ohne Befestigungsmittel funktionslos ist oder beim Lösen des Befestigungsmittels funktionslos wird.

Der neue Sicherheitsschalter verfügt damit über ein Befestigungsmittel mit einer Doppelfunktion. Es dient zum einen in an sich bekannter Weise dazu, den Betätiger physisch an dem einen der beweglichen Teile zu befestigen. Darüber hinaus besitzt das Befestigungsmittel nun jedoch auch eine schaltungstechnische Funktion. Nur dann, wenn das Befestigungsmittel ordnungsgemäß installiert ist, ist der Betätiger in der Lage, die ihm übertragene Funktion im Zusammenspiel mit dem Sensor zu erfüllen. Ohne Befestigungsmittel funktioniert der Betätiger nicht oder zumindest nicht wie im Normalbetrieb vorgesehen. Dabei kann das Nicht-Funktionieren des Betätigers reversibel oder irreversibel sein. Im erstgenannten Fall würde der Betätiger ordnungsgemäß funktionieren, sobald die Befestigungsmittel wie vorgesehen installiert sind. Damit ist es grundsätzlich möglich, den Betätiger zu demontieren und an anderer Stelle wieder zu montieren, sofern das erforderliche Befestigungsmittel zur Verfügung steht. Der letztgenannte Fall beinhaltet demgegenüber, dass der Betätiger bei einer Demontage zerstört wird. Praktische Ausführungsbeispiele für beide Alternativen sind weiter unten beschrieben.

Der neue Sicherheitsschalter besitzt gegenüber allen bislang bekannten Sicherheitsschaltern den Vorteil, dass ein weiterer Betrieb der Anlage nach Demontage des Betätigers gar nicht möglich ist oder zumindest mit einem erheblich höheren Aufwand als bislang verbunden ist. In dem Fall, dass ein Entfernen der Befestigungsmittel den Betätiger reversibel funktionslos macht, ist zwar eine Manipulation des Sicherheitsschalters nicht gänzlich ausgeschlossen. Dies gilt jedoch auch für die bislang praktizierte Vorgehensweise, wonach zwei sich ergänzende Sicherheitsschalter verwendet wurden. Realistisch beurteilt man die Gefahr von Manipulationen daher auch anhand des damit verbundenen Aufwandes. Wenn der Aufwand eher gering ist und die Manipulation zudem problemlos rückgängig gemacht werden kann, ist die Versuchung einer Manipulation sehr groß.

Bei dem neuen Sicherheitsschalter müsste der Betätiger mit dem zugehörigen Befestigungsmittel wieder "richtig" montiert werden. Eine provisorische Befestigung im Bereich des Sensors genügt im Gegensatz zu bisherigen Sicherheitsschaltern nicht mehr. Der Aufwand und auch die bei einer Manipulation hinterlassenen Spuren reduzieren die Wahrscheinlichkeit von Manipulationen erheblich.

Ein reversibles Funktionslosmachen des Betätigers bei Entfernen der Befestigungsmittel besitzt den Vorteil, dass der Sicherheitsschalter bei einer gewollten Demontage, beispielsweise bei einer Umrüstung der überwachten Anlage, nicht unbrauchbar wird. Ein irreversibles Funktionsloswerden erhöht in einem solchen Fall die Kosten, vergrößert allerdings auch den Manipulationsschutz.

In beiden Fällen bietet der neue Sicherheitsschalter einen Manipulationsschutz, der zumindest dem bislang erreichten Niveau entspricht. Im Unterschied zum Stand der Technik ist dieses Sicherheitsniveau jedoch mit einem einzigen Sicherheitsschalter und auf technisch sehr einfache und kostengünstige Weise möglich. Die genannte Aufgabe ist daher vollständig gelöst.

In einer bevorzugten Ausgestaltung weist der Betätiger des neuen Sicherheitsschalters zumindest zwei Bauelemente auf, die mit Hilfe des Befestigungsmittels funktionsfähig miteinander verbunden sind.

Diese Ausgestaltung ist sehr einfach und kostengünstig zu realisieren. Sie eignet sich insbesondere für Sicherheitsschalter auf Transponderbasis, bei denen im Betätiger typischerweise ein integrierter Schaltkreis mit dem Transpondercode und ein Antennenelement vorhanden sind. Trennt man die Verbindung zwischen diesen beiden Bauelementen elektrisch auf, kann diese Trennung durch leitfähige Befestigungsmittel einfach wiederhergestellt werden. Elektrischen Trennstellen sind bevorzugt verdeckt ausgeführt, so dass für einen Bediener, der den genannten Sicherheitsschalter nicht im Detail kennt, der Manipulationsschutz nicht ersichtlich ist.

In einer weiteren Ausgestaltung weist der Betätiger zumindest zwei Befestigungsmittel auf, und die zumindest zwei Bauelemente sind mit Hilfe jedes der zwei Befestigungsmittel funktionsfähig miteinander verbunden.

Diese Ausgestaltung zeigt sich im Hinblick auf die Zuverlässigkeit und Verfügbarkeit des neuen Sicherheitsschalters als vorteilhaft. Da es im Rahmen der vorliegenden Erfindung vor allem darauf ankommt, eine vollständige Demontage des Betätigers von seinem vorgesehenen Montageort zu verhindern, genügt es, ein Befestigungsmittel, beispielsweise eine Schraube, zum Funktionslosmachen des Betätigers zu verwenden. Die doppelte Ausführung sichert einen störungsfreieren Normalbetrieb, insbesondere bei Kontaktschwierigkeiten. Alternativ hierzu ist es grundsätzlich jedoch auch denkbar, mehrere Befestigungsmittel redundant zueinander zu verwenden, so dass der Betätiger bereits funktionslos wird, wenn nur eines der Befestigungsmittel entfernt wird. In diesem Fall ergibt sich ein höherer Manipulationsschutz.

In einer weiteren Ausgestaltung enthält der Betätiger ein Schaltelement, das mit dem Befestigungsmittel gekoppelt ist.

Diese Ausgestaltung ermöglicht es, die Schaltstellung des Schaltelements abhängig von dem Befestigungsmittel zu variieren. Damit ist gewissermaßen ein Ein- und Ausschalten des Betätigers mit Hilfe des Befestigungsmittels möglich. Diese Ausgestaltung besitzt den Vorteil, dass der Betätiger mit einer größeren Zuverlässigkeit funktionsfähig bzw. funktionslos gemacht werden kann. Darüber hinaus bietet diese Ausgestaltung eine größere Flexibilität, indem abhängig von dem Befestigungsmittel beispielsweise zwei oder mehr unterschiedliche Sendesignale erzeugt werden. Nur eines der Sendesignale signalisiert eine ordnungsgemäße Funktion im Sinne der Erfindung. Jedes andere Sendesignal ist ein "Nicht-Funktionieren" im Sinne der Erfindung. Daraus können dann Diagnosedaten abgeleitet werden, anhand deren man beispielsweise einen Manipulationsversuch auch nachträglich erkennen kann.

In einer weiteren Ausgestaltung ist das Schaltelement ein magnetisch betätigbares Schaltelement, insbesondere ein Reed-Kontakt, und das Befestigungsmittel beinhaltet einen Magneten.

Diese Ausgestaltung ist sehr robust und damit auch für raue gut Industrieumgebungen geeignet. Darüber hinaus kann der Betätiger dieser Ausgestaltung so realisiert werden, dass er ohne eigene Energieversorgung auskommt. Hierdurch vereinfacht sich die Montage und Wartung des neuen Sicherheitsschalters.

In einer weiteren Ausgestaltung enthält der Betätiger einen Transponder, der in Abhängigkeit von dem Befestigungsmittel das Sendesignal erzeugt.

Transponder sind elektrische Schaltungen, die eine individuelle Codierung enthalten und diese auf ein entsprechendes Abfragesignal hin ausstrahlen. Im Rahmen der vorliegenden Erfindung trägt ein Transponder auf Grund der individuellen Codierung zu einer noch höheren Manipulationssicherheit bei. Die Anfertigung eines Duplikats des Betätigers ist nur mit erheblichem Aufwand und Know-how möglich, wenn überhaupt.

In einer weiteren Ausgestaltung besitzt der Transponder ein Antennenelement und einen Signalerzeugungsschaltkreis, wobei das Schaltelement das Antennenelement und den Signalerzeugungsschaltkreis wahlweise miteinander verbindet.

Diese Ausgestaltung ist eine sehr einfache und dabei sehr wirkungsvolle Möglichkeit, um den gewünschten Manipulationsschutz zu realisieren. Darüber hinaus lässt sich diese Ausgestaltung mit Hilfe von handelsüblichen Bauteilen realisieren.

In einer weiteren Ausgestaltung besitzt der Transponder einen Signalerzeugungsschaltkreis, in dem das Schaltelement integriert ist.

Derzeit bekannte, handelsübliche Transponder verfügen nicht über ein integriertes Schaltelement, das für den vorliegenden Zweck geeignet ist. Insofern ist diese Ausgestaltung zunächst mit einem größeren Aufwand verbunden, da die Integration eines solchen Schaltelements eine Änderung im schaltungstechnischen Layout des Transponders erfordert. Andererseits ermöglicht diese Ausgestaltung eine noch höhere Manipulationssicherheit, da das Schaltelement in dieser Ausgestaltung weder ersichtlich noch zugänglich ist. Mit zunehmender Stückzahl amortisieren sich dann auch die Kosten für die Änderung im Transponderdesign.

In einer weiteren Ausgestaltung ist der Sensor dazu ausgebildet, mehrere Transponder zeitgleich auszuwerten.

Bislang wurden für gattungsgemäße Sicherheitsschalter ausschließlich Transponder (und entsprechende Sensoren) vorgeschlagen und verwendet, die einzeln ausgelesen und ausgewertet werden müssen. Die verwendeten Transponder erzeugten das Sendesignal, sobald sie in den Nahbereich des Sensor gelangten. Wenn mehrere Transponder im Nahbereich des Sensors waren, überlagerten sich deren Sendesignale und es konnte keine geeignete Auswertung erfolgen. Auf anderen Anwendungsgebieten, beispielsweise bei der logistischen Erfassung von Artikeln in einem Kaufhaus, sind jedoch sogenannte Antikollisionstransponder und entsprechende Auswerteschaltkreise bekannt. Mit diesen ist eine zeitgleiche Erfassung von mehreren Transpondersignalen möglich, wobei hier verschiedene Antikollisionsverfahren zum Einsatz kommen können, beispielsweise ein Slotted-ALOHA-Verfahren, wie es aus dem Bereich der Telekommunikation bekannt ist.

Die vorliegende Ausgestaltung verwendet einen für die zeitgleiche Auswertung von Transpondersignalen ausgebildeten Sensor (und dementsprechende Transponder in den Betätigern). Dies ermöglicht es, eine zwei- oder mehrflügelige Schutztür oder dergleichen mit nur einem Sensor zu überwachen. Es genügt, an jedem Flügel der Schütztür einen Betätiger anzuordnen, und zwar so, dass sämtliche Betätiger bei vollständig geschlossener Schütztür (alle Flügel geschlossen) im Bereich des Sensors sind. Aufgrund der Antikollisionseigenschaft kann der Sensor dann eine vollständig geschlossene Schutztür erkennen. Diese auch für sich genommen erfinderische Ausgestaltung besitzt in Kombination mit der vorliegenden Erfindung den Vorteil, dass mehrere Schutztürflügel, beispielsweise zweiflügelige Schiebetüren an einer Werkzeugmaschine, mit nur einem einzigen Sensor überwacht werden können. Die Installationskosten lassen sich damit deutlich reduzieren, ohne dass das Risiko von unerkannten Manipulationen vergrößert wird.

Besonders bevorzugt ist es darüber hinaus, wenn der Sensor der zuvorgenannten Ausgestaltung zumindest zwei getrennt schaltbare Ausgänge aufweist, weil er dann ein von den verschiedenen Betätigern abhängiges Ausgangssignal erzeugen kann. Beispielsweise kann dann ein Ausgang freigegeben werden, wenn ein erster Transponder detektiert wurde und ein zweiter Ausgang wird in Abhängigkeit von einem zweiten Betätiger geschaltet. Diese Ausgestaltung ermöglicht eine besonders flexible Anwendung und damit eine weitere Kostenreduzierung.

In der erfindungsgemäßen Ausgestaltung ist der Betätiger dazu ausgebildet, in Abhängigkeit von dem Befestigungsmittel eines von zumindest zwei verschiedenen Sendesignalen zu erzeugen.

Wie bereits weiter oben angesprochen, bietet eine solche Ausgestaltung eine höhere Flexibilität bei der praktischen Gestaltung. Darüber hinaus ist in dieser Ausgestaltung eine sehr einfache Diagnose möglich. Beispielsweise sendet ein Transponder bei ordnungsgemäß installiertem Befestigungsmittel, d.h. in einem ersten Betriebszustand, eine erste Transpondercodierung, und ohne Befestigungsmittel eine zweite, unterschiedliche Transpondercodierung. Dann lässt sich der Zustand "Schutztür geöffnet" daran erkennen, dass überhaupt kein Transpondersignal empfangen wird, weil der Abstand zwischen Transponder und Sensor zu groß ist. Anhand des empfangenen Transpondersignals kann andererseits zwischen den Zuständen "Betätiger ordnungsgemäß installiert" und "Betätiger manipuliert" unterschieden werden. Die dem Sicherheitsschalter nachgeordnete Auswerteeinheit besitzt damit die Möglichkeit, auf die verschiedenen Zustände individuell zu reagieren, beispielsweise ein Alarmsignal zu erzeugen, das die Manipulation an eine übergeordnete Stelle meldet. Diese bevorzugte Ausgestaltung erhöht den Manipulationsschutz somit weiter.

In einer weiteren Ausgestaltung beinhaltet der Betätiger zumindest zwei Transponder, die in Abhängigkeit von dem Befestigungsmittel alternativ zueinander funktionsfähig geschaltet sind.

Diese Ausgestaltung ermöglicht eine einfache Diagnose der zuvor beschriebenen Art, wobei in diesem Fall handelsübliche Transponder verwendet werden können. Die oben genannten Vorteile sind daher mit dieser Ausgestaltung erreichbar, ohne in das schaltungstechnische Layout des Transponders eingreifen zu müssen. Damit ist diese Ausgestaltung besonders vorteilhaft für die schnelle Realisierung des neuen Sicherheitsschalters und/oder für die Produktion des neuen Sicherheitsschalters in geringen Stückzahlen.

In einer weiteren Ausgestaltung ist das Befestigungsmittel irreversibel. Insbesondere beinhaltet es eine Klebeverbindung und/oder eine sogenannte Sicherungsschraube, die jeweils nur eine einmalige Montage zulassen. Im letztgenannten Fall ist es bevorzugt, wenn in der Sicherungsschraube ein Magnet integriert ist, der bevorzugt ein entsprechendes Schaltelement im Betätiger aktiviert. Bei Verwendung einer Klebeverbindung ist es besonders bevorzugt, wenn der Betätiger ein folienartiges "Gehäuse" besitzt, das beim gewaltsamen Lösen der Klebeverbindung zerreißt, so dass ein integriertes Antennenelement von dem Signalerzeugungsschaltkreis abgerissen wird.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: eine schematische Darstellung einer automatisierten Anlage mit einer Schutztür, die über den neuen Sicher- heitsschalter abgesichert ist,
- Fig. 2: eine vereinfachte Darstellung eines Betätigers für den neuen Sicherheitsschalter gemäß einem ersten Ausfüh- rungsbeispiel,
- Fig. 3: ein vereinfachtes elektrisches Schaltbild für den Betä- tiger aus Fig. 2,
- Fig. 4: ein vereinfachtes elektrisches Schaltbild eines weite- ren Ausführungsbeispiels des neuen Sicherheitsschal- ters,
- Fig. 5: ein weiteres Ausführungsbeispiel des neuen Sicherheits- schalters,
- Fig. 6: ein weiteres Ausführungsbeispiel des neuen Sicherheits- schalters, und
- Fig. 7: ein weiteres Ausführungsbeispiel des neuen Sicherheits- schalters zum Absichern einer mehrflügeligen Schutztür.

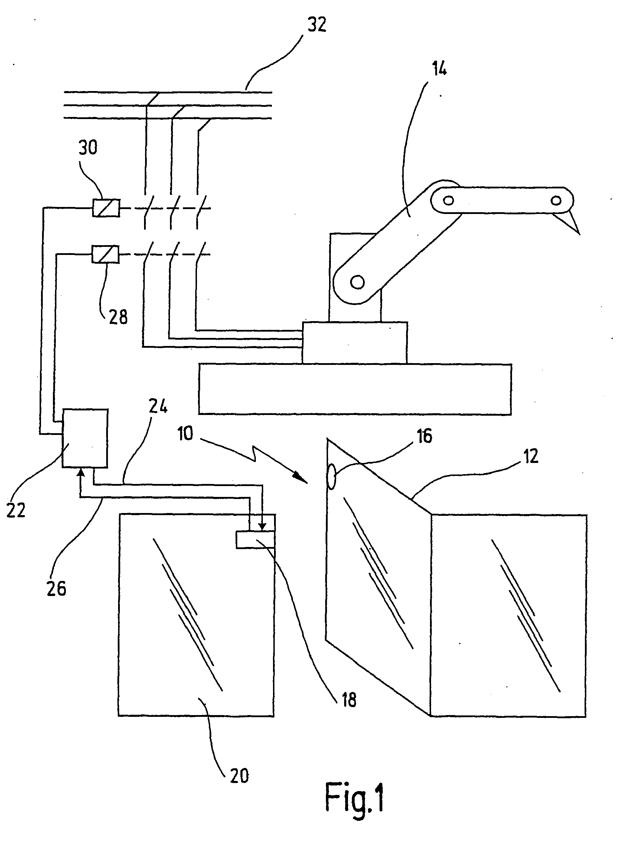

In Fig. 1 ist ein Ausführungsbeispiel des neuen Sicherheitsschalters mit der Bezugsziffer 10 bezeichnet. Der Sicherheitsschalter 10 dient hier zum Überwachen der Schließposition einer Schutztür 12, die ihrerseits zum Absichern einer automatisiert arbeitenden Anlage vorgesehen ist. Beispielhaft ist die automatisiert arbeitende Anlage hier als Roboter 14 dargestellt. Der Einsatzbereich des neuen Sicherheitsschalters 10 ist jedoch nicht auf dieses konkrete Anwendungsbeispiel beschränkt. Generell kann der neue Sicherheitsschalter zum Überwachen jeder (Schließ-)position zweier relativ zueinander beweglicher Teile verwendet werden. Dies beinhaltet beispielsweise auch die Überwachung einer Kolbenposition relativ zu einem Kolbenzylinder oder relativ zu einem anderen Kolben.

Der Sicherheitsschalter 10 beinhaltet einen Betätiger 16 und einen Sensor 18. Der Betätiger 16 ist an der Schutztür 12 angebracht. Der Sensor 18 ist an einer Wand 20 (oder an einem hier nicht dargestellten Rahmen für die Schutztür 12) angebracht. Im geschlossenen Zustand der Schutztür 12 (hier nicht dargestellt) befindet sich der Betätiger 16 in räumlicher Nähe zum Sensor 18. Der Sensor 18 kann diesen Zustand auf Grund eines vom Betätiger 16 erzeugten Sendesignals erkennen. Beim Öffnen der Schutztür 12 wird der Betätiger 16 vom Sensor 18 entfernt, was zur Folge hat, dass der Sensor 18 eine entsprechende Meldung für ein nachfolgendes Sicherheitsschaltgerät 22 erzeugt.

Der Sensor 18 ist in diesem Ausführungsbeispiel über zwei Leitungen 24, 26 mit dem Sicherheitsschaltgerät 22 verbunden. Eine erste Leitung 24 führt vom Sicherheitsschaltgerät 22 zum Sensor 18. Über diese Leitung kann das Sicherheitsschaltgerät 22 Testsignale an den Sensor 18 übertragen, um dessen Funktionssicherheit zu überprüfen. Ein geeignetes Verfahren hierzu ist beispielsweise in der deutschen Patentanmeldung DE 103 34 653.8 beschrieben. Alternativ hierzu (oder auch ergänzend) kann der Sensor 18 zweikanalig ausgebildet sein, wie aus DE 197 11 588 A1 bekannt.

Über die zweite Leitung 26 empfängt das Sicherheitsschaltgerät 22 die vom Sensor 18 erzeugten Meldesignale.

Ausgangsseitig steuert das Sicherheitsschaltgerät 22 zwei Schütze 28, 30, deren Arbeitskontakte die Stromversorgung 32 des Roboters 14 unterbrechen. Über die Schütze 28, 30 kann das Sicherheitsschaltgerät 22 den Roboter 14 abschalten, wenn mit Hilfe der Betätiger-Sensor-Kombination 16, 18 ein Öffnen der Schutztür 12 festgestellt wird oder wenn bei den kontinuierlichen internen Funktionstests im Sicherheitsschalter 10 und/oder im Sicherheitsschaltgerät 22 ein sicherheitskritischer Zustand erkannt wird.

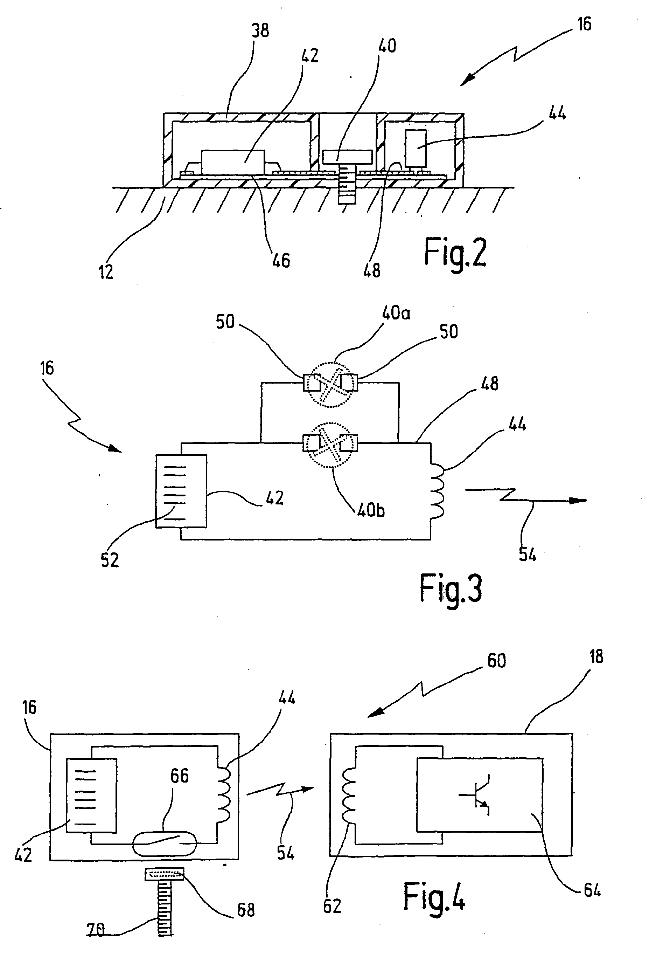

Gemäß Fig. 2 ist der Betätiger 16 hier in einem Gehäuse 38 untergebracht, das hinsichtlich seiner Stabilität, Staubdichtheit und ähnlichen Anforderungen an die Einsatzumgebung im Bereich des Roboters 14 angepasst ist. Bevorzugt handelt es sich um ein Gehäuse nach IP 67.

Das Gehäuse 38 ist über Befestigungsschrauben 40 (hier nur eine dargestellt) auf die Schutztür 12 aufgeschraubt. Innerhalb des Gehäuses 38 sind ein Signalerzeugungsschaltkreis 42 und eine Spule 44 auf einer Leiterplatte 46 angeordnet.

Schaltkreis 42 und Spule 44 sind durch entsprechende Leiterbahnen 48 elektrisch miteinander verbindbar. Tatsächlich ist die elektrische Verbindung zwischen den beiden Bauelementen jedoch im Bereich der Befestigungsschrauben 40 unterbrochen. Durch Einschrauben der Befestigungsschrauben 40 wird die elektrische Verbindung hergestellt und der Signalerzeugungsschaltkreis 42 und die Spule 44 arbeiten dann in an sich bekannter Weise als Transponder.

Fig. 3 zeigt das elektrische Schaltbild des Betätigers aus Fig. 2, wobei gleiche Bezugszeichen dieselben Elemente bezeichnen wie zuvor. Die Leiterbahn 48 besitzt hiernach zwei Parallelzweige, die jeweils unterbrochen sind und an den offenen Enden vergrößerte Kontaktflächen 50 aufweisen. Die Befestigungsschrauben 40 (in Fig. 3 als 40a und 40b bezeichnet) schließen den elektrischen Kontakt, wenn sie an den Kontaktflächen 50 anliegen. Dies ist im vollständig eingeschraubten Zustand der Fall.

Der Signalerzeugungsschaltkreis 42 ist ein integrierter Schaltkreis mit einer Transponderfunktionalität. Er besitzt eine interne, individuelle Codierung, die in Fig. 3 bei der Bezugsziffer 52 angedeutet ist. Über die Spule 44 kann der Signalerzeugungsschaltkreis 42 induktiv mit Energie versorgt werden. Sobald dies geschieht, moduliert der Signalerzeugungsschaltkreis 42 das empfangne Signal mit seiner internen Codierung und sendet es über die Spule 44 als codiertes Sendesignal 54 zurück. Das Sendesignal 54 wird in an sich bekannter Weise von einer geeigneten Auswerteschaltung ausgewertet.

Da der Signalerzeugungsschaltkreis 42 und die Spule 44 in diesem Ausführungsbeispiel nur dann elektrisch miteinander verbunden sind, wenn zumindest eine Befestigungsschraube 40 auf den Kontaktflächen 50 aufliegt, würde eine Demontage des Betätigers 16 dazu führen, dass der Betätiger 16 funktionslos wird. Eine einfache Manipulation des Sicherheitsschalters 10 dadurch, dass man den Betätiger 16 demontiert und im Bereich des Sensors 18 mit Klebeband fixiert, ist wirkungsvoll verhindert.

Ein zusätzlicher Manipulationsschutz wird erreicht, wenn die Befestigungsschrauben 40 als Sicherungsschrauben ausgebildet sind, die nur eine einmalige Montage erlauben. Des Weiteren können die Schraubenköpfe 40 so ausgebildet sein, dass sie ein spezielles Montagewerkzeug zum Einschrauben erfordern. Würde nun versucht, die Schrauben 40 durch Aufbohren zu entfernen (was bereits einen erheblichen Aufwand darstellt), ist die Wahrscheinlichkeit sehr hoch, dass dabei auch die Kontaktflächen 50 zerstört würden, so dass der Betätiger 16 insgesamt unbrauchbar wird.

In dem Ausführungsbeispiel gemäß Fig. 2 liegen die Schrauben 40 tief versenkt im Gehäuse 38 des Betätigers 16. Zudem ist der Abstand der einander gegenüberliegenden Kontaktflächen 50 relativ groß gewählt. Dies hat zur Folge, dass bei einer erneuten Montage nur wenige ausgewählte Schrauben 40 verwendet werden können. Darüber hinaus ist der hiesige Manipulationsschutz von außen ohne nähere Kenntnis der im Betätiger 16 realisierten Zusammenhänge kaum zu erkennen.

In Fig. 4 ist ein weiteres Ausführungsbeispiel des neuen Sicherheitsschalters in seiner Gesamtheit mit der Bezugsziffer 60 bezeichnet. Der Sicherheitsschalter 60 ist hier mit einem vereinfachten elektrischen Ersatzschaltbild dargestellt. Demnach beinhaltet der Sensor 18 eine Spule 62, die mit einem Auswerteschaltkreis 64 ("Tag-Reader") verbunden ist. Anstelle der Spule 62 kann auch ein Schwingkreis bestehend aus Spule 62 und einem parallel oder seriell dazu angeordneten Kondensator (hier nicht dargestellt) verwendet sein. Darüber hinaus besitzt der Sensor 18 einen schaltungstechnischen Aufbau, der den Anforderungen an die Eigenfehlersicherheit gemäß Kategorie 3, bevorzugt Kategorie 4, der EN 954-1 bzw. vergleichbaren Anforderungen entspricht. Eine geeignete Realisierung des Sensors 18 ist in der schon erwähnten DE 103 34 653.8 oder auch in DE 197 11 588 A1 beschrieben.

Der Betätiger 16 besitzt hier wiederum einen Signalerzeugungsschaltkreis 42 und eine Spule 44, die gemeinsam einen Transponder bilden. Der Signalerzeugungsschaltkreis 42 und die Spule 44 sind hier allerdings über ein Schaltelement 66 voneinander getrennt. Das Schaltelement 66 ist in einem bevorzugten Ausführungsbeispiel ein Reed-Kontakt, der über ein äußeres Magnetfeld geschlossen werden kann. Zum Schließen des Reed-Kontaktes 66 dient in diesem Ausführungsbeispiel ein kleiner Magnet 68, der in der Befestigungsschraube (hier mit Bezugsziffer 70 bezeichnet) angeordnet ist. Die Befestigungsschraube 70 kann wiederum als Sicherungsschraube ausgebildet sein, die nur durch mechanische Zerstörung wieder entfernt werden kann.

Solange sich die Befestigungsschraube 70 an ihrem vorgesehenen Montageort befindet, wird der Reed-Kontakt 66 in einer geschlossenen Position gehalten. Daher ist der Betätiger 16 im montierten Zustand funktionsfähig. Wird die Befestigungsschraube 70 entfernt, öffnet sich der Reed-Kontakt 66, und der Betätiger 16 wird funktionslos.

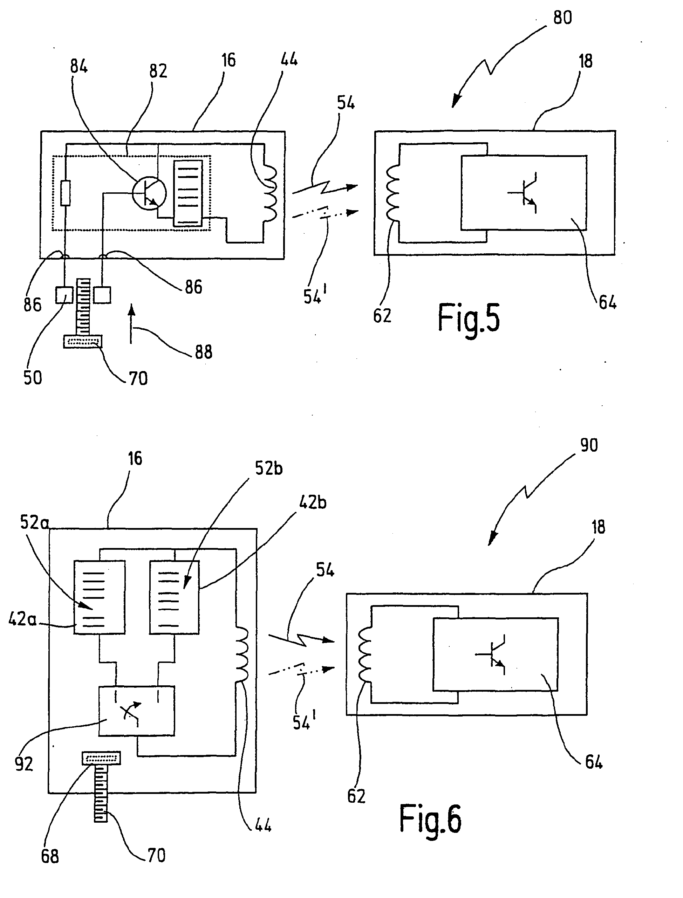

In Fig. 5 ist ein weiteres Ausführungsbeispiel des neuen Sicherheitsschalters in seiner Gesamtheit mit der Bezugsziffer 80 bezeichnet. In diesem Fall ist im Betätiger 16 ein Signalerzeugungsschaltkreis 82 verwendet, der ein integriertes Schaltelement 84 besitzt, welches über einen Eingang 86 von außen schaltbar ist. Im Montagebereich des Betätigers 16 sind zwei Kontaktflächen 50 angeordnet, die über eine Befestigungsschraube 70 überbrückt werden können. Dies ist der Fall, wenn die Befestigungsschraube 70 in Richtung des Pfeils 88 in eine entsprechende Aufnahme am Montageort des Betätigers 16 eingeschraubt ist. Im gezeigten Ausführungsbeispiel wird über die Schraube 70 ein Potential an den Eingang des Schaltelements 84 geschaltet, was zur Folge hat, dass der Signalerzeugungsschaltkreis 82 die individuelle Codierung über die Spule 44 übertragen kann. Fehlt das entsprechende Potential am Eingang 86, überträgt der Signalerzeugungsschaltkreis 82 entweder ein anderes codiertes Sendesignal 54' oder er erzeugt überhaupt kein Sendesignal 54. In beiden Fällen ist der Signalerzeugungsschaltkreis 82 nicht mehr in der Lage, die vorgesehene Funktion, nämlich die Übertragung der erstgenannten Codierung, zu erfüllen.

In Fig. 6 ist ein weiteres Ausführungsbeispiel des neuen Sicherheitsschalters mit der Bezugsziffer 90 bezeichnet. In diesem Fall beinhaltet der Betätiger 16 ein Schaltelement 92, das als Umschalter zwischen zwei Signalerzeugungsschaltkreisen 42a und 42b fungiert. Die Signalerzeugungsschaltkreise 42a, 42b besitzen unterschiedliche Codierungen 52a, 52b. Abhängig davon, ob sich die Befestigungsschraube 70 im Bereich des Betätigers 16 befindet, sendet der Betätiger 16 das eigentlich vorgesehene Sendesignal 54 oder ein anderes Sendesignal 54', wobei letzteres wiederum bedeutet, dass der Betätiger 16 nicht ordnungsgemäß im Sinne der Erfindung funktioniert. Die Schraube 70 kann wiederum über einen Magneten 68 auf das Schaltelement 92 einwirken. Das Schaltelement 92 kann jedoch auch auf andere Weise, beispielsweise wie anhand Fig. 5 gezeigt, betätigt werden. Diese Ausführung mit einem Umschalter ist besonders vorteilhaft, weil mit handelsüblichen Transpondern unterschiedliche, vom Befestigungsmittel abhängige Codierungen erzeugt werden können.

In einem weiteren, hier nicht bildlich dargestellten Ausführungsbeispiel sind der Signalerzeugungsschaltkreis 42 und die Spule 44 in einem Foliengehäuse verschweißt und als solches auf der Schutztür 12 festgeklebt. Die Klebeverbindung ist derart beschaffen, dass das Foliengehäuse beim gewaltsamen Entfernen des Betätigers 16 zerreißt, wobei die Spule 44 vom Signalerzeugungsschaltkreis 42 abgetrennt wird. Dieses Ausführungsbeispiel besitzt im Vergleich zu den zuvor beschriebenen Varianten den Nachteil, dass der Betätiger 16 auch nach einer zulässigen Demontage ersetzt werden muss, so dass beispielsweise eine Umrüstung der überwachten Maschine mit zusätzlichen Kosten für einen neuen Betätiger verbunden wäre. Demgegenüber müssten bei den zuvor genannten Ausführungsbeispielen allenfalls die Befestigungsschrauben ersetzt werden (wenn diese als Sicherungsschrauben ausgebildet sind), was jedoch billiger ist als ein neuer Transponder.

Die in Fig. 6 dargestellte Verwendung eines Betätigers 16, der abhängig von einem äußeren Signal (dort abhängig von der Befestigungsschraube 70) unterschiedliche Codierungen sendet, ermöglicht weitere Anwendungsfälle im Bereich der Sicherheitstechnik. Da sich mit einer solchen Anordnung letztlich drei (oder mehr) verschiedene Zustände unterscheiden lassen, nämlich Transpondersignal 1, Transpondersignal 2 oder kein Transpondersignal, könnte beispielsweise ein drahtloser und batterieloser Zustimmschalter realisiert werden, der einen eingeschränkten Betrieb einer überwachten Anlagen ermöglicht.

Darüber hinaus basieren die bislang gezeigten Ausführungsbeispiele alle auf einem Betätiger mit Transponder. Abweichend hiervon kann die Erfindung jedoch auch mit anderen Betätigern realisiert werden. Beispielsweise könnte der aus DE 102 22 186 C1 bekannte Betätiger so abgewandelt werden, dass er ohne das Befestigungsmittel keine Energie zurücksendet und somit funktionslos ist.

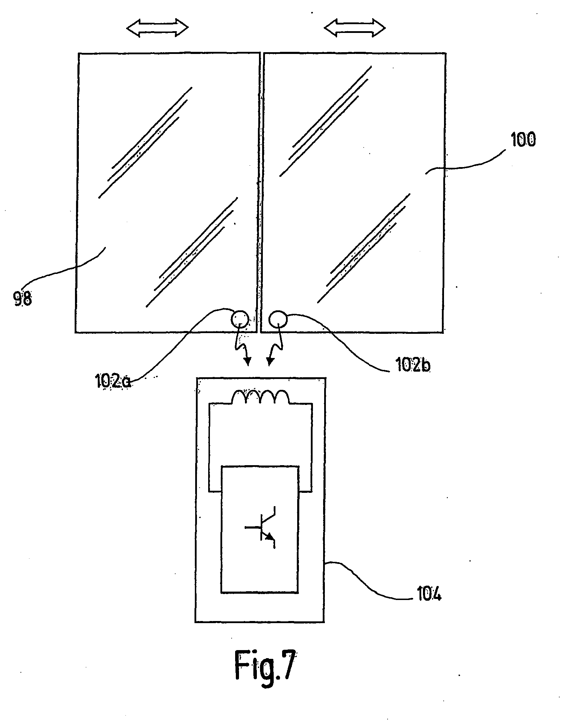

In Fig. 7 dient ein Ausführungsbeispiel des neuen Sicherheitsschalters zum Absichern einer zweiflügeligen Schiebetür, wie sie beispielsweise an Werkzeugmaschinen häufig verwendet wird, um den Arbeitsbereich der Maschine zu verschließen. Die beiden Flügel der Schiebtür sind mit den Bezugsziffern 98 und 100 bezeichnet. An der unteren inneren Ecke jedes Flügels 98, 100 ist jeweils ein Betätiger 102a, 102b angeordnet, der jeweils einen Transponder (hier nicht dargestellt) beinhaltet. Bei geschlossenen Flügeln 98, 100 befinden sich beide Betätiger 102a, 102b im Bereich des Sensors 104, der so ausgebildet ist, dass er die Transponder der beiden Betätiger zeitgleich auswerten kann. Der Ssensor 104 beinhaltet dementsprechend einen Auswerteschaltkreis 106, der ein Antikollisionsverfahren beim Auslesen der Transponder in den Betätigern 102 implementiert.

## Patentansprüche

1. Sicherheitsschalter zum Überwachen einer Schließposition zweier relativ zueinander beweglicher Teile (12, 20), insbesondere zum Überwachen einer Schutztür an einer automatisierten Anlage, mit einem Betätiger (16; 102) und mit einem Sensor (18; 104), die an jeweils einem der Teile fixierbar sind, wobei der Betätiger (16; 102) zumindest ein Bauelement (42, 44; 82, 44) aufweist, das dazu ausgebildet ist, ein von der Schließposition der Teile abhängiges erstes Sendesignal (54) zu erzeugen und wobei der Sensor (18; 104) dazu ausgebildet ist, das Sendesignal (54) auszuwerten, um die Schließposition zu detektieren, wobei der Betätiger (16) ferner zumindest ein Befestigungsmittel (40; 70) zum Befestigen an dem einem der Teile (12) aufweist, **dadurch gekennzeichnet, dass** das Befestigungsmittel (40; 70) mit dem Bauelement (42, 44; 82, 44) so verbunden ist, dass der Betätiger (16) in Abhängigkeit von dem Befestigungsmittel (70) eines von zumindest zwei verschiedenen, unterschiedlich codierten Sendesignalen (54, 54') erzeugt, wobei nur eines der verschiedenen Sendesignale (54, 54') einen ordnungsgemäß installierten Betätiger signalisiert, so dass der Betätiger ohne das Befestigungsmittel (40; 70) funktionslos ist oder beim Lösen des Befestigungsmittels (40; 70) funktionslos wird.

2. Sicherheitsschalter nach Anspruch 1, **dadurch gekennzeichnet, dass** der Betätiger (16) ein Schaltelement (66; 84; 92) enthält, das mit dem Befestigungsmittel (70) gekoppelt ist.

3. Sicherheitsschalter nach Anspruch 2, **dadurch gekennzeichnet, dass** das Schaltelement ein magnetisch betätigbares Schaltelement (66), insbesondere ein Reed-Kontakt, ist und dass das Befestigungsmittel (70) einen Magneten (68) beinhaltet.

4. Sicherheitsschalter nach einem der Ansprüche 1 bis 3, **dadurch gekennzeichnet, dass** der Betätiger (16) einen Transponder (42, 44; 82, 44) enthält, der in Abhängigkeit von dem Befestigungsmittel (70) zumindest das eine Sendesignal (54) erzeugt.

5. Sicherheitsschalter nach Anspruch 4, **dadurch gekennzeichnet, dass** der Transponder ein Antennenelement (44) und einen Signalerzeugungsschaltkreis (42a, 42b) besitzt, wobei das Schaltelement (66) das Antennenelement (44) und den Signalerzeugungsschaltkreis (42a, 42b) wahlweise miteinander verbindet.

6. Sicherheitsschalter nach Anspruch 4 oder 5, **dadurch gekennzeichnet, dass** der Transponder einen Signalerzeugungsschaltkreis (82) besitzt, in dem das Schaltelement (84) integriert ist.

7. Sicherheitsschalter nach einem der Ansprüche 4 bis 6, **dadurch gekennzeichnet, dass** der Sensor (104) dazu ausgebildet ist, mehrere Transponder (102) zeitgleich auszuwerten.

8. Sicherheitsschalter nach einem der Ansprüche 1 bis 7, **dadurch gekennzeichnet, dass** der Betätiger (16) zumindest zwei Transponder (42a, 42b) beinhaltet, die in Abhängigkeit von dem Befestigungsmittel (70) alternativ zueinander funktionsfähig geschaltet sind.

9. Sicherheitsschalter nach einem der Ansprüche 1 bis 8, **dadurch gekennzeichnet, dass** das Befestigungsmittel (40; 70) irreversibel ist, insbesondere zumindest eine Sicherungsschraube und/oder eine Klebeverbindung beinhaltet.

## Claims

1. Safety switch for monitoring a closing position of two relatively movable parts (12, 20), particularly for monitoring a protective door of an automated system, comprising an actuator (16; 102) and a sensor (18; 104), which can be respectively fastened to one of the parts, wherein the actuator (16; 102) has at least one device (42, 44; 82, 44), which is provided to generate a first signal (54) depending on the closing position of the parts and wherein the sensor (18; 104) is provided to evaluate the signal (54) to detect the closing position, wherein the actuator (16) further has at least one fixing means (40; 70) for fixing to one of the parts (12), **characterized in that** the fixing means (40; 70) is connected to the device (42, 44; 82, 44) such that the actuator (16) generates one of at least two different and differently coded signals (54, 54') depending on the fixing means (70), wherein only one of the different signals (54, 54') indicates a properly installed actuator, so that the actuator without the fixing means (40; 70) is disabled or is disabled during release of the fixing means (40; 70).

2. Safety switch of claim 1, **characterized in that** the actuator (16) includes a switching member (66; 84; 92), which is coupled to the fixing means (70).

3. Safety switch of claim 2, **characterized in that** the switching member is a magnetically operable switching member (66), particularly a reed contact, and that the fixing means (70) includes a magnet (68).

4. Safety switch of any of claims 1 to 3, **characterized in that** the actuator (16) includes a transponder (42, 44; 82, 44), which generates at least one signal (54) depending on the fixing means (70).

5. Safety switch of claim 4, **characterized in that** the transponder comprises an antenna member (44) and a signal generating circuit (42a, 42b), wherein the switching member (66) selectively connects the antenna member (44) and the signal generating circuit (42a, 42b) to one another.

6. Safety switch of claim 4 or 5, **characterized in that** the transponder comprises a signal generating circuit (82), in which the switching member (84) is integrated.

7. Safety switch of any of claims 4 to 6, **characterized in that** the sensor (104) is provided to evaluate a plurality of transponders (102) at the same time.

8. Safety switch of any of claims 1 to 7, **characterized in that** the actuator (16) includes at least two transponders (42a, 42b), which are enabled alternately to one another depending on the fixing means (70).

9. Safety switch of any of claims 1 to 8, **characterized in that** the fixing means (40; 70) is irreversible, particularly including at least one locking screw and/or an adhesive joint.

## Revendications

1. Interrupteur de sécurité pour surveiller une position fermée de deux parties se déplaçant l'une par rapport à l'autre (12, 20), en particulier pour surveiller une porte de sécurité dans une installation automatisée, comprenant un organe de commande (16 ; 102) et un capteur (18 ; 104) qui peuvent être fixés respectivement sur l'une des parties, l'organe de commande (16 ; 102) présentant au moins un composant (42, 44 ; 82, 44) qui est réalisé pour produire un premier signal émetteur (54) dépendant de la position fermée des parties et le capteur (18 ; 104) étant réalisé pour exploiter le signal émetteur (54) afin de détecter la position fermée, l'organe de commande (16) présentant en outre au moins un moyen de fixation (40 ; 70) permettant de le fixer sur l'une des parties (12), **caractérisé en ce que** le moyen de fixation (40 ; 70) est relié au composant (42, 44 ; 82, 44) de telle sorte que l'organe de commande (16) produit, en fonction du moyen de fixation (70), un signal émetteur (54, 54') parmi au moins deux signaux émetteurs distincts, codés différemment, un seul des signaux émetteurs (54, 54') distincts signalant un organe de commande dûment installé, de sorte que l'organe de commande est inopérant sans le moyen de fixation (40 ; 70) ou devient inopérant lorsque le moyen de fixation (40 ; 70) est détaché.

2. Interrupteur de sécurité selon la revendication 1, **caractérisé en ce que** l'organe de commande (16) comprend un élément de commutation (66 ; 84 ; 92) couplé avec le moyen de fixation (70).

3. Interrupteur de sécurité selon la revendication 2, **caractérisé en ce que** l'élément de commutation est un élément de commutation (66) à fonctionnement magnétique, en particulier un contact à lames souples, et **en ce que** le moyen de fixation (70) comporte un aimant (68).

4. Interrupteur de sécurité selon l'une des revendications 1 à 3, **caractérisé en ce que** l'organe de commande (16) comprend un transpondeur (42, 44 ; 82, 44) qui produit, en fonction du moyen de fixation (70), au moins un signal émetteur (54) parmi les signaux émetteurs.

5. Interrupteur de sécurité selon la revendication 4, **caractérisé en ce que** le transpondeur contient un élément d'antenne (44) et un circuit de production de signaux (42a, 42b), l'élément de commutation (66) reliant au choix l'élément d'antenne (44) et le circuit de production de signaux (42a, 42b).

6. Interrupteur de sécurité selon la revendication 4 ou 5, **caractérisé en ce que** le transpondeur contient un circuit de production de signaux (82) dans lequel l'élément de commutation (84) est intégré.

7. Interrupteur de sécurité selon l'une des revendications 4 à 6, **caractérisé en ce que** le capteur (104) est conformé pour exploiter simultanément plusieurs transpondeurs (102).

8. Interrupteur de sécurité selon l'une des revendications 1 à 7, **caractérisé en ce que** l'organe de commande (16) comporte au moins deux transpondeurs (42a, 42b) qui sont commutés en fonction du moyen de fixation (70) alternativement l'un par rapport à l'autre de manière opérationnelle.

9. Interrupteur de sécurité selon l'une des revendications 1 à 8, **caractérisé en ce que** le moyen de fixation (40 ; 70) est irréversible, et qu'il comporte en particulier au moins une vis de blocage et/ou un assemblage par collage.
